# EUROPÄISCHE PATENTSCHRIFT

(11) **EP 1 230 684 B1**
(45) Veröffentlichungstag und Bekanntmachung des Hinweises auf die Patenterteilung: **17.06.2009**
(21) Anmeldenummer: 00972563.1
(22) Anmeldetag: 26.08.2000
(51) Int. Cl.: H01L 29/861

(54) **VERFAHREN ZUR HERSTELLUNG EINES HALBLEITERBAUELEMENTS**
METHOD FOR THE PRODUCTION OF A SEMICONDUCTOR COMPONENT
PROCEDE DE PRODUCTION D'UN COMPOSANT A SEMI-CONDUCTEUR

(30) Priorität: 08.09.1999 DE 19942879
(43) Veröffentlichungstag der Anmeldung: 14.08.2002
(73) Patentinhaber: ROBERT BOSCH GMBH, 70442 Stuttgart (DE)
(72) Erfinder: SPITZ, Richard, 72766 Reutlingen (DE)
(86) Internationale Anmeldenummer: PCT/DE2000/002918
(87) Internationale Veröffentlichungsnummer: WO 2001/018879

(56) Entgegenhaltungen:
- WO-A-01/13434
- DE-A- 4 135 258
- DE-A- 4 201 183
- FR-A- 2 319 972
- US-A- 4 220 963

## Beschreibung

### Stand der Technik

Die Erfindung geht aus von einem Halbleiterbauelement bzw. einem Verfahren zur Herstellung nach der Gattung des unabhängigen Anspruchs. Aus der DE 36 33 161 A1 ist bereits eine Gleichrichterdiode bekannt, bei der neben einer einfachen pn-Schichtenfolge weitere Layoutmaßnahmen vorgesehen sind zur Erzielung eines verbesserten Erholungsverhaltens (engl. "recovery behavior") bei Kommutierung.

Aus der DE-A-4 135 258 ist ein Halbleiterbauelement bzw. ein Herstellungsverfahren für ein Halbleiterbauelement bekannt, welches in einem bestimmten Bereich eine Vertiefung aufweist, in einem anderen dagegen nicht. Dadurch wird ein Bauelement mit einer Schicht mit unterschiedlicher Dicke erhalten. Die eingebrachten Vertiefungen werden durch Sägen erzeugt und weisen Rundungen auf.

Die Herstellung von Vertiefungen mittels Sägen ist auch aus der FR-A-2 319 972 bekannt. Dabei erfolgt das Sägen nach dem belegen des Wafers mit Dotieratomen, weshalb der vertiefte Bereich einen pn-Übergang durchtrennt.

Aus der nicht vorveröffentlichten Druckschrift WO-A-01/13434 ist ein Halbleiterbauelement bzw. ein Herstellungsverfahren für ein Halbleiterbauelement bekannt, bei dem die Vertiefungen gesägt werden, aber kein rechteckförmiger Grabenquerschnitt offenbart ist.

### Vorteile der Erfindung

Das erfindungsgemäße Verfahren mit den Merkmalen des unabhängigen Anspruchs hat demgegenüber den Vorteil, ohne zusätzliche Layoutmaßnahmen die Bereitstellung von Halbleiterbauelementen mit hohen Taktfrequenzen und damit verbunden kleinen Schaltzeiten zu ermöglichen, ohne daß der Ausräumstrom beim Umpolen in Sperrichtung steil abfällt. Dadurch wird in einfacher Weise sichergestellt, daß trotz kurzer Schaltzeiten keine steilen Stromabrisse aufgrund immer vorhandener Streuinduktivitäten zu hohen Störspannungsspitzen führen; somit wird es möglich, in einfacher Weise schnell schaltende Bauelemente in Kraftfahrzeugen für Gleichrichteranordnungen einzusetzen, bei denen ansonsten solche Spannungsspitzen beispielsweise den Radioempfang stören würden. Darüber hinaus gewährleistet die erfindungsgemäß erhaltene Diode neben der kurzen Schaltzeit und einem sanften Abfall des Ausräumstroms eine niedrige Flußspannung und somit niedrige Wärmeverluste bei Polung der am Bauelement anliegenden Spannung in Durchlaßrichtung.

Durch die in den abhängigen Ansprüchen aufgeführten Maßnahmen sind vorteilhafte Weiterbildungen und Verbesserungen des in dem unabhängigen Anspruch angegebenen Verfahrens möglich.

Die Erfindung verwendet Gräben mit rechteckförmigem Querschnitt, um mit möglichst wenig Gräben das gewünschte Verhältnis zwischen Bereichen unterschiedlicher Mittelzonendicke herzustellen.

Werden die Randbereiche durch keine Vertiefungen aufweisende Bereiche gebildet, so ist das erzeugte Bauelement unempfindlich gegen Beschädigungen und Verunreinigungen an der Chipkante.

Weitere Vorteile ergeben sich durch die in der Beschreibung genannten Merkmale.

### Zeichnung

Ausführungsbeispiele der Erfindung sind in der Zeichnung dargestellt und in der nachfolgenden Beschreibung näher erläutert. Figur 1 zeigt eine Gleichrichterdiodee, Figur 2 ein Diagramm, Figur 3a eine Querschnittsseitenansicht einer Diode, Figur 3b eine Draufsicht auf eine Diode.

### Beschreibung der Ausführungsbeispiele

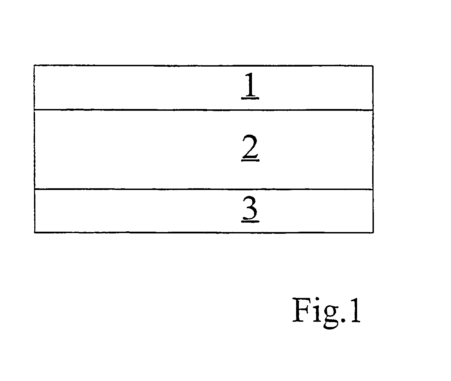

Figur 1 zeigt eine Halbleiterdiode mit einer schwach n-dotierten Mittelzone 2, die auf ihrer Oberseite mit einer stark p-dotierten Schicht 1 und auf ihrer Unterseite mit einer stark n-dotierten Schicht 3 bedeckt ist. Die Schichten 1 und 3 sind mit (nicht eingezeichneten) Metallisierungen versehen.

Die Schichten 1 und 2 bilden an ihrer gemeinsamen Grenzfläche den pn-Übergang der Halbleiterdiode.

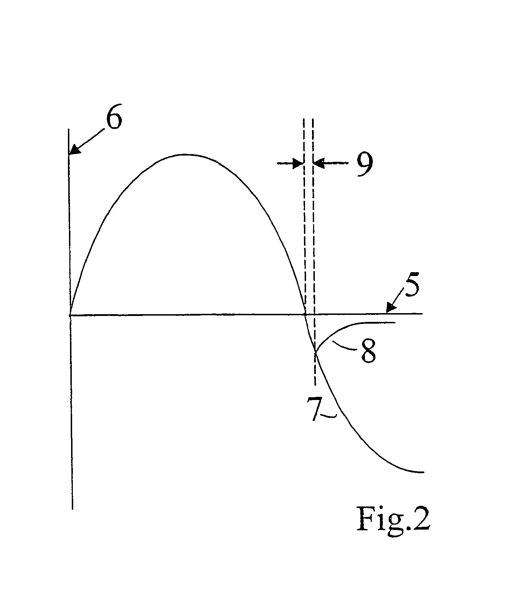

Figur 2 zeigt ein Diagramm mit einer Zeitachse 5 und einer Ordinatenachse 6. Dargestellt ist ein sinusförmiger Spannungsverlauf 7, der an den Schichten 1 und 3 der Halbleiterdiode der Figur 1 angelegt ist. In Durchlaßrichtung folgt der Strom durch die Diode im wesentlichen dem Spannungsverlauf 7, also der positiven Halbwelle des Spannungsverlaufs 7 in der linken Hälfte des Diagramms. Wechselt die Spannung 7 das Vorzeichen, so wird die Diode in Sperrichtung gepolt, der Strom durch die Diode folgt noch eine kurze Zeit, die so genannte Schaltzeit 9, ungefähr dem Spannungsverlauf, bis er in die Ausräumstromkurve 8 übergeht.

Beim Umschalten von Fluß- in Sperrichtung müssen in die Mittelzone indizierte Ladungsträger ausgeräumt werden, bevor die Diode in der Lage ist, die Sperrspannung aufzunehmen. Die hierzu notwendige Zeit ist die Schaltzeit 9.

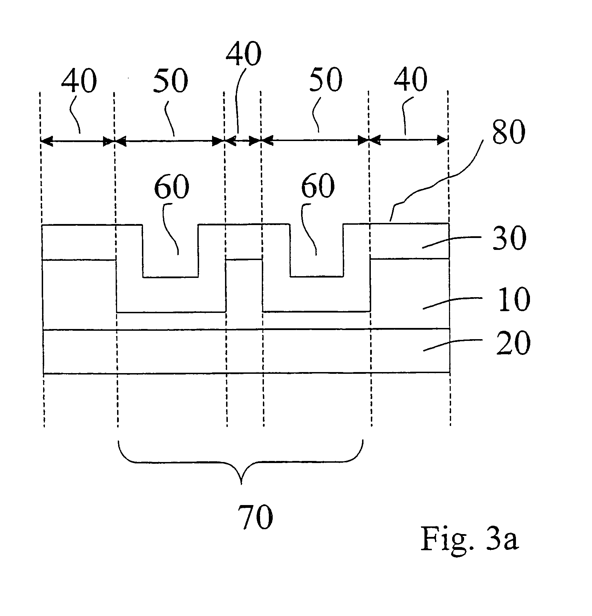

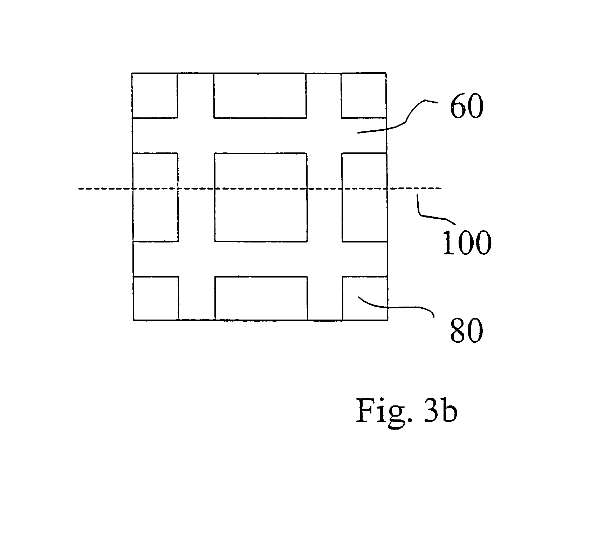

In der Querschnittsseitenansicht der Figur 3a ist eine Schichtenfolge 10, 20, 30 dargestellt, die eine Diode bildet. Die Schicht 10 ist n-dotiert und entspricht der Dotierung eines bei der Herstellung dieses Bauelements verwendeten schwach n-dotierten Substrats. Auf der Unterseite der Schicht 10 ist eine stark n-dotierte Schicht 20 aufgebracht, die ihrerseits an ihrer Außenseite mit einer (nicht eingezeichneten) Metallisierung versehen ist. Auf der Oberseite der Schicht 10 ist eine stark p-dotierte Schicht 30 aufgebracht. In die Oberseite der Diode sind Gräben 60 eingebracht, die erste Bereiche 40 und zweite Bereiche 50 definieren. In den ersten Bereichen 40 ist die Schicht 10 dicker ausgelegt als in den zweiten Bereichen 50, während die Schicht 30 in beiden Bereichen ungefähr die gleiche Dicke aufweist. Die Gräben 60 befinden sich im Innenbereich 70 der Diode, während der restliche Bereich der Diode, der Randbereich, durch erste Bereiche 40 gebildet wird. Auf der Oberfläche 80 der Diode ist wiederum eine (nicht eingezeichnete) Metallisierung aufgebracht. In der Draufsicht in Figur 3b ist mit der Querschnittslinie 100 die Stelle markiert, für die in Figur 1a die Querschnittsseitenansicht abgebildet ist. Auf der Oberfläche 80 sind parallel zu den Außenkanten der Diode eingebrachte Gräben 60 ersichtlich, wobei die Gräben sich kreuzen und jeweils zwei parallele Gräben parallel zu jeder Außenkante des Bauelements angeordnet sind. Die Tiefe der Gräben 60 beträgt beispielsweise zirka 70 Mikrometer, die Dicke der Schicht 10 im Bereich 40 zirka 80 Mikrometer und die Dicke der Schicht 10 im Bereich 50 zirka 10 Mikrometer. Die Dicken der Schichten 20 und 30 betragen jeweils zirka 60 Mikrometer. Die Dotierkonzentration in der Schicht 10 beträgt beispielsweise zirka 4*10¹⁴cm⁻³, die Dotierkonzentrationen an den Oberflächen der Schichten 20 und 30 (die Oberfläche der Schicht 30 ist in Figur 3a mit Bezugszeichen 80 versehen) jeweils zirka 7*10¹⁹cm⁻³_{.}

Der Bereich 40 stellt einen hochsperrenden Diodenteil mit breiter Mittelzone 10 dar (Durchbruchspannung ≥ 200 Volt), der Bereich 50 einen hochsperrenden Diodenteil (Durchbruchspannung ≥ 100 Volt) mit schmaler Mittelzone 10. Der Bereich 40 weist aufgrund der dicken Mittelzone einen sanften Ausräumstromabfall auf, der Bereich 50 mit der schmalen Mittelzone führt zu einer kurzen Schaltzeit und einer niedrigen Flußspannung des Halbleiterbauelements. Der Randbereich des Chips wird durch Bereiche 40 gebildet, so daß wegen der höheren Durchbruchspannung der Bereiche 40 im Vergleich zu den Bereichen 50 die Feldstärke am Chiprand niedrig bleibt. Die Diode wird dadurch unempfindlich gegen Beschädigungen und Verunreinigungen an der Chipkante. Fließen mindestens 25% des Flußstroms der Diode durch Bereiche 40, so ist ein äußerst sanfter Stromabfall nach Umpolung der Spannung in Diodensperrichtung gewährleistet.

In einer alternativen Ausführungsform ist der Anteil der Bereiche 50 an der Gesamtchipfläche so ausgelegt, daß mindestens 50% des Stroms durch die Bereiche 50 fließen können, um gleichzeitig zur Gewährleistung eines sanften Stromabfalls für sehr niedrige Flußspannungen zu sorgen. Dies kann durch eine entsprechende Anzahl von Gräben bzw. durch eine entsprechende Wahl der Breite der Gräben gewährleistet werden. Neben quadratischen Chips können auch fünf-, sechs-, oder mehreckige Chips mit den erfindungsgemäßen Gräben versehen werden, die parallel zu den jeweiligen Kanten des Chips angeordnet werden und sich entsprechend in einem fünf-, sechs-, oder mehreckigen Muster kreuzen. Beim ersten Leitfähigkeitstyp handelt es sich um eine n-Leitung, beim zweiten Leitfähigkeitstyp um eine p-Leitung. Selbstverständlich kann auch eine umgekehrte Wahl getroffen werden. Auch andere Halbleiterbauelemente als Dioden können in vorteilhafter Weise mit den erfindungsgemaß hergestellten Gräben versehen werden. Insbesondere bei Drei- oder Vierschichtdioden, also Transistor- oder Tyristordioden, bilden dann die Schichten 30 und 10 die Basis-/Kollektorschichten bzw. die p- und die n-Schicht des mittleren pn-Übergangs.

Die Halbleiterdioden gemäß Figur 3 ermöglichen die Realisierung hoher Taktfrequenzen aufgrund ihrer kurzen Schaltzeiten. Sie sind daher insbesondere geeignet, in Kraftfahrzeug-Brückengleichrichteranordnungen eingesetzt zu werden, bei denen Taktfrequenzen verwendet werden, die deutlich über den Frequenzen normaler passiver Diodengleichrichter liegen. Bei getakteten Gleichrichtern wie beispielsweise in der nicht vorveröffentlichten deutschen Patentanmeldung mit dem Aktenzeichen 198 45 569.0 beschrieben, können mit den beschriebenen Halbleiterdioden mit Gräben Taktfrequenzen von ca. 20kHz realisiert werden, was ca. eine Größenordnung höher ist als die konventionelle Frequenz bekannter KFZ-Gleichrichteranordnungen, die an die Drehzahl des Generators gekoppelt ist und ca. maximal 2kHz beträgt.

Zur Herstellung eines Diodenchips nach Figur 3 werden zunächst parallele Gräben 60 in einen Wafer gesägt, der die Dotierung der späteren Schicht 10 aufweist. Anschließend werden die stark p- und die stark n-dotierten Schichten 30 bzw. 20 simultan eindiffundiert. In einem weiteren Schritt wird auf beiden Seiten des Wafers jeweils eine Metallschicht abgeschieden. Der Wafer wird in einem weiteren Schritt durch Sägen in einzelne Chips zertrennt, wobei die Zertrennungslinien in den Bereichen 40 verlaufen, in denen die Mittelzone 10 dick ist im Vergleich zu den Bereichen 50, in den die Gräben 60 eingebracht sind. Der Chip kann beispielsweise in bekannte Einpreßdiodengehäuse eingelötet und mit Epoxidharz ummantelt werden.

Um möglichst große Bereiche 50 zu erhalten sind die Gräben mit rechteckigen Profilen zu sägen. Die Anzahl der Gräben pro Chip bestimmt sich aus den festgelegten Flächenproportionen von Bereich 40 zu Bereich 50 und aus der gewählten Grabenbreite.

Das erfindungsgemäße Verfahren kommt zur Bereitstellung solcher Bauelemente ohne zusätzliche Diffusionsschichten bzw. ohne zusätzliche Layoutmaßnahmen aus. Es handelt sich um ein großserientaugliches, teilweise, zumindest was das Einbringen der Gräben betrifft, außerhalb des Reinraumes durchführbares Verfahren.

## Patentansprüche

1. Verfahren zur Herstellung von Halbleiterbauelementen, wobei in einer Seite eines Wafers eines ersten Leitfähigkeitstyps Vertiefungen eingebracht werden, in einem nachfolgenden Schritt beide Seiten des Wafers mit Dotieratomen belegt werden und ein Diffusionsprozeß erfolgt, wobei in einem weiteren Schritt eine Zerteilung des Wafers in einzelne Chips erfolgt, so dass jeder Chip in seinem Innenbereich (70) mindestens eine Vertiefung (60) aufweist, die als Graben mit rechteckförmigem Querschnitt ausgebildet ist, **dadurch gekennzeichnet, dass** die mindestens eine Vertiefung gesägt wird.

2. Verfahren nach Anspruch 1, **dadurch gekennzeichnet, dass** vor dem Zerteilen des Wafers auf beide Seiten des Wafers Metallschichten aufgebracht werden.

3. Verfahren nach einem der vorhergehenden Ansprüche, **dadurch gekennzeichnet, dass** die Zerteilung in Bereichen (40) des Wafers erfolgt, in denen keine Vertiefungen eingebracht worden sind.

4. Verfahren nach einem der vorhergehenden Ansprüche, **dadurch gekennzeichnet, dass** bei der Belegung der die Vertiefungen aufweisenden Seite ein Dotierstoff eines zweiten Leitfähigkeitstyps verwendet wird.

5. Verfahren nach einem der vorhergehenden Ansprüche, **dadurch gekennzeichnet, dass** bei der Belegung der anderen Seite ein Dotierstoff des ersten Leitfähigkeitstyps verwendet wird.

6. Verfahren nach einem der vorhergehenden Ansprüche, **dadurch gekennzeichnet, dass** nach den Belegungen die Metallschichten auf die eine und die andere Seite aufgebracht werden.

## Claims

1. Method for the production of semiconductor components, wherein depressions are introduced in a side of a wafer of a first conductivity type, in a subsequent step both sides of the wafer are coated with doping atoms and a diffusion process is effected, wherein in a further step the wafer is separated into individual chips, such that each chip has in its inner region (70) at least one depression (60) embodied as a trench having a rectangular cross section, **characterized in that** the at least one depression is sawn.

2. Method according to Claim 1, **characterized in that** prior to the wafer being separated, metal layers are applied to both sides of the wafer.

3. Method according to any of the preceding claims, **characterized in that** the separation is effected in regions (40) of the wafer in which no depressions were introduced.

4. Method according to any of the preceding claims, **characterized in that** a dopant of a second conductivity type is used when coating the side having the depressions.

5. Method according to any of the preceding claims, **characterized in that** a dopant of the first conductivity type is used when coating the other side.

6. Method according to any of the preceding claims, **characterized in that** after the coating, the metal layers are applied to the one and the other side.

## Revendications

1. Procédé de production de composants semiconducteurs, dans lequel :
des creux d'un premier type de conductivité sont formés sur une face d'une plaquette,
lors d'une étape ultérieure, les deux faces de la plaquette sont pourvues d'atomes de dopage et une opération de diffusion est conduite,
lors d'une étape ultérieure, une division de la plaquette en puces individuelles a lieu, de sorte que chaque puce présente dans sa zone interne (70) au moins un creux (60) configuré en forme de sillon de section transversale rectangulaire,
**caractérisé en ce que**
le ou les creux sont sciés.

2. Procédé selon la revendication 1, **caractérisé en ce que** des couches de métal sont déposées sur les deux faces de la plaquette avant la division de la plaquette.

3. Procédé selon l'une des revendications précédentes, **caractérisé en ce que** la division est effectuée dans des zones (40) de la plaquette dans lesquelles aucun creux n'a été formé.

4. Procédé selon l'une des revendications précédentes, **caractérisé en ce qu'**une substance de dopage d'un deuxième type de conductivité est utilisée lors du revêtement de la face présentant les creux.

5. Procédé selon l'une des revendications précédentes, **caractérisé en ce qu'**une substance de dopage du premier type de conductivité est utilisée lors du revêtement de l'autre face.

6. Procédé selon l'une des revendications précédentes, **caractérisé en ce que** les couches de métal sont déposées sur l'une et l'autre face après les revêtements.
